(19) Europäisches Patentamt
European Patent Office
Office européen des brevets

(11) EP 3 057 147 A1

(12) # EUROPEAN PATENT APPLICATION
published in accordance with Art. 153(4) EPC

(43) Date of publication:
**17.08.2016 Bulletin 2016/33**

(21) Application number: **14866170.5**

(22) Date of filing: **10.11.2014**

(51) Int Cl.:
***H01L 41/193*** *(2006.01)* ***C08G 63/06*** *(2006.01)*
***H01L 41/33*** *(2013.01)* ***H01L 41/45*** *(2013.01)*

(86) International application number:
**PCT/JP2014/079773**

(87) International publication number:
**WO 2015/079899 (04.06.2015 Gazette 2015/22)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **26.11.2013 JP 2013244320**

(71) Applicant: **Mitsui Chemicals, Inc.**
**Tokyo 105-7117 (JP)**

(72) Inventors:
- **TANIMOTO, Kazuhiro**
  **Nagoya-shi, Aichi 457-8522 (JP)**
- **YOSHIDA, Mitsunobu**
  **Nagoya-shi, Aichi 457-8522 (JP)**
- **NISHIKAWA, Shigeo**
  **Nagoya-shi, Aichi 457-8522 (JP)**

(74) Representative: **Hoffmann Eitle**
**Patent- und Rechtsanwälte PartmbB**
**Arabellastraße 30**
**81925 München (DE)**

(54) **MACROMOLECULAR PIEZOELECTRIC MATERIAL AND MANUFACTURING METHOD THEREFOR**

(57) There is provided a polymeric piezoelectric material including a helical chiral polymer (A) having a weight-average molecular weight of from 50,000 to 1,000,000 and an optical purity of more than 97.0%ee but less than 99.8%ee as calculated by the following formula, in which a piezoelectric constant $d_{14}$ measured at 25°C by a stress-charge method is 1pC/N or more:

$$\text{Formula: optical purity (\%ee)} = 100 \times |\text{L-form amount} - \text{D-form amount}| / (\text{L-form amount} + \text{D-form amount}),$$

[in which an amount of L-form (% by mass) and an amount of D-form of an optically active polymer (% by mass) are values obtained by a method using high-performance liquid chromatography (HPLC)].

EP 3 057 147 A1

## Description

### Technical Field

The present invention relates to a polymeric piezoelectric material and a method of producing the material.

### Background Art

In recent years, polymeric piezoelectric materials have been reported which are based on helical chiral polymers having optical activity (for example, a polylactic acid-type polymer).

For example, a polymeric piezoelectric material is disclosed which exhibiting a piezoelectric modulus of approximately 10 pC/N at a normal temperature, which is attained by a stretching treatment of a molding of polylactic acid (for example, see Japanese Patent Application Laid-Open (JP-A) No. 5-152638).

Further, a layered film obtained by a co-extrusion method is also known, which is a polymeric piezoelectric material having a layer A the main component of which is poly L-lactic acid and a layer B the main component of which is poly D-lactic acid (*e.g.*, see JP-A-2011-243606).

### SUMMARY OF INVENTION

### Technical Problem

For a polymeric piezoelectric material using a helical chiral polymer having optical activity, molecular chains are thought to be desirably oriented in a single direction in order to manifest piezoelectricity.

However, it has been revealed from an investigation of the inventors that the following problems may arise in a case in which molecular chains are oriented in a single direction in the polymeric piezoelectric material.

When molecular chains are oriented in a single direction in the above-described polymeric piezoelectric material, the polymeric piezoelectric material may tend to be easily torn in the single direction. Such a tendency of tearing in a single direction is a property that is not seen for biaxially stretched polyester films and injection-molded products of helical chiral polymer already applied in various fields. Accordingly, in a case in which the above-described polymeric piezoelectric material is applied as a device, *etc.,* the property may cause a practically serious problem, such as crack generation in the direction of tearing tendency, during producing steps or after product completion.

Thus, tear strength may be needed to be further improved for the above-described polymeric piezoelectric material.

On the other hand, the stability of piezoelectric constants is also needed to be improved from the viewpoint of reducing variation in product quality for the above-described polymeric piezoelectric material.

However, it has been revealed that from an investigation of the inventors, improvement in tear strength may decrease the stability of piezoelectric constants (especially, thermal stability) for the above-described polymeric piezoelectric material. Conversely, it has been revealed that improvement in the stability of piezoelectric constants (especially, thermal stability) may decrease tear strength for the above-described polymeric piezoelectric material.

The present invention has been made in view of the above, and set a challenge to achieve the following object.

Thus, an object of the invention is to provide a polymeric piezoelectric material in which improvements in tear strength and in stability of piezoelectric constants are both realized, and a method of producing the material.

### Solution to Problem

Specific measures to attain the object are as follows.

<1> A polymeric piezoelectric material including a helical chiral polymer having a weight-average molecular weight of from 50,000 to 1,000,000 and having an optical purity of more than 97.0%ee but less than 99.8%ee as calculated by using the following formula, in which a piezoelectric constant $d_{14}$ measured at 25°C by a stress-charge method is 1 pC/N or more.

$$\text{Formula: optical purity (\%ee)} = 100\ |\text{L-form amount} - \text{D-form amount}|\ /\ (\text{L-form amount} + \text{D-form amount}),$$

[in which an amount of L-form (% by mass) and an amount of D-form of an optically active polymer (% by mass) are values obtained by a method using a high-performance liquid chromatography (HPLC)].

<2> The polymeric piezoelectric material according to <1>, in which the above-described optical purity is from 98.0%ee to 99.6%ee.

<3> The polymeric piezoelectric material according to <1> or <2>, in which the above-described optical purity is more than 98.5%ee but less than 99.6%ee.

<4> The polymeric piezoelectric material according to any one of <1> to <3>, in which an internal haze with respect to visible light is 40% or less, a crystallinity obtained by a DSC method is from 20% to 80%, and a product of the crystallinity and a standardized molecular orientation MORc measured by a microwave transmission type molecular orientation meter based on a reference thickness of 50 μm is from 40 to 700.

<5> The polymeric piezoelectric material according to any one of <1> to <4>, in which an internal haze with respect to visible light is from 0.05% to 5%, and a standardized molecular orientation MORc measured by a microwave transmission type molecular orientation meter based on a reference thickness of 50 μm is from 2.0 to 10.0.

<6> The polymeric piezoelectric material according to any one of <1> to <5>, in which the helical chiral polymer (A) is a polylactic acid-type polymer having a main chain including a repeating unit represented by the following formula (1):

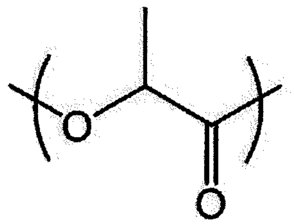

(1)

<7> The polymeric piezoelectric material according to any one of <1> to <6>, in which a content of the helical chiral polymer (A) is 80% by mass or more.

<8> A method of producing the polymeric piezoelectric material according to any one of <1> to <7>, the method including a first step of heating a film in an amorphous state including the helical chiral polymer (A) to obtain a pre-crystallized film, and a second step of stretching the pre-crystallized film principally in a uniaxial direction.

<9> The method of producing the polymeric piezoelectric material according to <8>, in which the first step heats the film in an amorphous state at a temperature T, which satisfies the following formula (2) until the crystallinity becomes from 3% to 70%, to obtain the pre-crystallized film.

$$\text{Formula (2): } Tg - 40°C \leq T \leq Tg + 40°C$$

[In formula (2), Tg represents is a glass-transition temperature (°C) of the helical chiral polymer (A).]

<10> The method of producing the polymeric piezoelectric material according to <8> or <9>, in which the first step heats the film in an amorphous state including polylactic acid as the helical chiral polymer (A) at from 60°C to 170°C for from 5 seconds to 60 minutes to obtain the pre-crystallized film.

<11> The method of producing the polymeric piezoelectric material according to any one of <8> to <10> further including an annealing treatment step of conducting an annealing treatment after the second step.

The term "film" is, herein, a concept encompassing sheet.

In addition, the ranges of numerical value represented by the expression " to" means, herein, to include numerical values before and after " to" as lower and upper limits, respectively.

Advantageous Effects of Invention

According to the invention, there is provided a polymeric piezoelectric material in which improvements in tear strength and in stability of piezoelectric constants are both realized, and a method of producing the material.

BRIEF DESCRIPTION OF DRAWINGS

Fig. 1 is a conceptual diagram indicating the cut-out direction of a specimen in the measurement of tear strength of

the present embodiment.

Fig. 2 is a graph indicating an increasing rate (%) of the piezoelectric constant $d_{14}$ and a result of tear strength in Examples and Comparative Examples in the present application.

DESCRIPTION OF EMBODIMENTS

[Polymeric Piezoelectric material]

A polymeric piezoelectric material according to the invention includes a helical chiral polymer (A) having a weight-average molecular weight of from 50,000 to 1,000,000 and an optical purity of more than 97.0%ee but less than 99.8%ee, in which a piezoelectric constant $d_{14}$ is 1 pC/N or more measured at 25°C by a stress-charge method.

After an intensive investigation, the inventors have found that in the polymeric piezoelectric material which includes a helical chiral polymer having a weight-average molecular weight of from 50,000 to 1,000,000, and which has a piezoelectric constant $d_{14}$ (hereinafter, also simply referred to as "piezoelectric constant") of 1 pC/N or more measured at 25°C by a stress-charge method, improvements in tear strength and in stability of piezoelectric constants (especially, thermal stability) is both realized when the optical purity of the helical chiral polymer is within an extremely limited range of more than 97.0%ee but less than 99.8%ee, and they has completed the invention.

In the invention, the optical purity of more than 97.0%ee leads to improvement in the stability of piezoelectric constants.

The presumed reason is that the optical purity of more than 97.0%ee leads to improvement in the crystallinity of the helical chiral polymer, resulting in increase in piezoelectric constants of the polymeric piezoelectric material, and as a consequence, the stability of piezoelectric constants are also improved.

In addition, in the invention, the optical purity of less than 99.8%ee leads to improvement in the tear strength.

The presumed reason is that the optical purity of the helical chiral polymer of less than 99.8%ee keeps to some extent the ratio of the amorphous part of the polymeric piezoelectric material, and as a consequence, the toughness of the polymeric piezoelectric material is improved.

The optical purity is preferably from 98.0%ee to 99.6%ee, and more preferably more than 98.5%ee but less than 99.6%ee, from the view point of balancing improvement in tear strength and improvement in the stability of piezoelectric constants (especially, moist heat resistance) at an higher level.

The optical purity of a helical chiral polymer (A) in the invention is a value calculated according to the following formula:

$$\text{Optical purity (\%ee)} = 100 \times |\text{L-form amount - D-form amount}| / (\text{L-form amount + D-form amount})$$

In other words, it is a value of "the difference (absolute value) between L-form amount [mass %] of the helical chiral polymer (A) and D-form amount [mass %] of the helical chiral polymer (A)" divided by "the total of L-form amount [mass %] of the helical chiral polymer (A) and D-form amount [mass %] of the helical chiral polymer (A)" multiplied by "100" is defined as optical purity.

The amount of the L-form (L-form amount) [% by mass] and the amount of the D-form (D-form amount) [% by mass] mean values measured by using high-performance liquid chromatography (HPLC). The detail of the measurement method is as follows.

To 1.0g of the polymeric piezoelectric material according to the invention are added 2.5 mL of IPA (isopropyl alcohol) and 5 mL of an aqueous solution of 5.0 mol/L sodium hydroxide, and the obtained solution is heated to 40°C to hydrolyze a helical chiral polymer (A) in the polymeric piezoelectric material according to the invention.

Next, the obtained hydrolyzed liquid is neutralized with 20 mL of hydrochloric acid solution of 1.0 mol/L.

Next, a mobile phase is added to 1.0 mL from the solution after the neutralization to prepare 25 mL of a HPLC sample solution. The used mobile phase is a solution of 1.0 mM copper (II) sulfate buffer and IPA mixed at a volume ratio [1.0 mM copper (II) sulfate buffer/IPA] of 98/2.

Then, using the above- obtained HPLC sample solution, the mobile phase, an optical resolution column, and an ultraviolet detector using ultraviolet light at a wavelength of 254 nm under a condition of column temperature of 25°C and the flow rate of the mobile phase of 1.0 mL/ min, the amount of the L-form of the helical chiral polymer (A) [% by mass] and that of the D-form of the helical chiral polymer (A) [% by mass] are both measured.

Well-known methods can be used for adjusting the optical purity of the helical chiral polymer (A) to be more than 97.0%ee but less than 99.8%ee.

For example, the methods include a method of adjusting the ratio of the D-form and the L-form in a raw material (monomer or oligomer) to adjust the optical purity of a finally-obtained helical chiral polymer to be within the above-mentioned range: a method of mixing helical chiral polymers to adjust the optical purity of the finally-obtained helical chiral polymer to be within the above-mentioned range: a method of controlling isomerization amount by the amount of a polymerizing catalyst, polymerization temperature, and polymerization time: a method of any combination thereof; and the like.

As a helical chiral polymer (A) having an optical purity of more than 97.0%ee and less than 99.8%ee, commercially available products described hereinafter can also be used.

Further in the invention, the stability of piezoelectric constants can be, for example, evaluated by the increasing rate of a piezoelectric constant $d_{14}$ from a reliability test (high temperature test).

Specifically, a lower increasing rate of the piezoelectric constant $d_{14}$ represented by the following formula (A) indicates further improvement in the stability of the piezoelectric constants.

$$\text{Increasing rate of the piezoelectric constant } d_{14}\ (\%) = ((\text{piezoelectric constant } d_{14} \text{ after reliability test} - \text{piezoelectric constant } d_{14} \text{ before reliability test}) / \text{piezoelectric constant } d_{14} \text{ before reliability test}) \times 100 \quad \text{Formula (A)}$$

Also in the invention, tear strength means tear strength measured according to the "Right angled tear method" stipulated in JIS K 7128-3 (1998).

In this measurement, the measurement direction (tearing direction) is a direction of larger tear tendency.

For example, in a case in which the polymeric piezoelectric material is a film stretched in a MD direction (longitudinally stretched), a specimen 12 is cut out of the film 10 so that the longitudinal direction of the specimen 12 stipulated by JIS K 7128-3(1998) is parallel to the TD direction of the film 10 (direction of the arrow TD), as shown in Fig. 1, and tear strength is measured upon tearing the central part in the longitudinal direction of the specimen 12 in the MD direction of the film (direction of the arrow MD).

When the polymeric piezoelectric material is a film stretched in the TD direction (transversely stretched), a specimen is, although not illustrated, cut out of the film so that the longitudinal direction of the specimen is parallel to the MD direction of the film, and tear strength is measured upon tearing the specimen in the TD direction of the film.

In the measurement, the crosshead speed of a tensile testing machine is set at 200 mm/min, tear strength is calculated according to the following formula:

$$T = F/d,$$

[wherein, T stands for the tear strength (N/mm), F for the maximum tear load, and d for the thickness (mm) of a specimen.]

<Piezoelectric Constant $d_{14}$>

The polymeric piezoelectric material according to the invention has a piezoelectric constant $d_{14}$ of 1pC/N or more measured at 25°C by a stress-charge method.

Now, one example will be explained of methods for measuring a piezoelectric constant $d_{14}$ by the stress-charge method (25°C).

First, the polymeric piezoelectric material is cut into a size of 150 mm in a 45° direction with respect to the stretching direction (for example MD direction) and 50 mm in a direction perpendicular to the 45° direction, to prepare a rectangular specimen. Next, the obtained specimen is placed on the testing stage of a SIP-600 by Showa Shinku Co., Ltd., and Al is vapor-deposited on one surface of the specimen until the thickness of the deposited Al becomes about 50 nm. Then, the deposition is performed similarly on the other surface of the specimen to cover both of the surfaces of the specimen with Al to form electrically conductive layers.

The specimen of a 150 mm×50 mm size (polymeric piezoelectric material) having Al electrically conductive layers on both of the surface thereof is cut into a size of 120 mm in a 45° direction with respect to the stretching direction (for example MD direction) and 10 mm in the direction perpendicular to the 45° direction, to form a rectangular film of a size of 120 mm×10 mm. This is treated as a sample for measuring a piezoelectric constant (hereinafter, simply referred to as a "sample").

The obtained sample is set in a tension testing machine (TENSILON RTG-1250, by AND Company, Limited) with an inter-chuck distance of 70 mm so that the sample dose not become loosened. Then, force is applied periodically in such way that the applied force varies between 4N and 9N at a crosshead speed of 5 mm/min. At this time, for measuring the amount of charge generated in the sample in response to the applied force, a capacitor of capacitance

Qm (F) is connected parallel to the sample, and the voltage V across the terminals of this capacitor Cm (95 nF) is measured via a buffer amplifier. The above operation is performed under the sample temperature condition of 25°C.

The amount of the generated charge Q (C) is calculated as a product of the capacity of the capacitor Cm and the voltage across the terminals Vm. The piezoelectric constant $d_{14}$ is calculated by according to the following formula:

$$d_{14} = (2 \times t)\ L \times Cm \cdot \Delta Vm / \Delta F,$$

t: sample thickness (m),
L: inter-chuck distance (m),
Cm: capacity of capacitor (F) connected in parallel,
$\Delta Vm / \Delta F$: ratio of the variation amount of the voltage across the capacitor terminals to the variation amount of the force.

A higher value of a piezoelectric constant $d_{14}$ is useful, because when it is higher, the displacement of the polymeric piezoelectric material in response to the voltage applied thereto becomes larger, and conversely, the voltage generated in response to the force applied thereto becomes higher. In other words, a higher value of the piezoelectric constant $d_{14}$ indicates the superior piezoelectricity of the polymeric piezoelectric material.

The piezoelectric constant $d_{14}$ in the invention is 1 pC/N or more, and preferably 4 pC/N or more, more preferably 6 pC/N or more, and further preferably 8 pC/N or more.

In addition, although the piezoelectric constant $d_{14}$ does not have any particular upper limit, the piezoelectric constant $d_{14}$ is preferably 50 pC/N or less, and more preferably 30 pC/N or less from the viewpoint of balancing with transparency, *etc.* of the polymeric piezoelectric material.

In this specification, the "MD direction" means a flow direction of a film (Machine Direction), and the "TD direction" means a direction perpendicular to the MD direction and parallel to the principal plane of the film (Transverse Direction).

<Internal Haze>

For the polymeric piezoelectric material according to the invention, from the viewpoint of its transparency, internal haze with respect to visible light is preferably 40% or less.

In the invention, the internal haze means a total haze from which a haze caused by the shape of an external surface of the polymeric piezoelectric material is excluded.

The internal haze is a value measured for the polymeric piezoelectric material having a thickness 0.05mm using a haze meter [TC-HIII DPK, by Toky o Denshoku, Co,. Ltd.] at 25°C according to JIS-K7105.

An example of method of measuring the internal haze in the invention will now be described.

First, only silicon oil (Shin-Etsu Silicone (trade mark), by Shin-Etsu Chemical Co., Ltd., model number: KF96-100CS) is previously placed between two glass plates to measure haze (H2), and then, the polymeric piezoelectric material according to the invention having the surface wetted uniformly with the silicon oil is placed between two glass plates to measure haze (H3). Then, the difference between these hazes is calculated according to the following formula to obtain the internal haze (H1) of the polymeric piezoelectric material according to the invention.

$$\text{Internal haze (H1)} = \text{haze (H3)} - \text{haze (H2)}$$

For the haze (H2) and the haze (H3), light transmittance in a thickness direction is measured under the following measurement condition using the following apparatus.

Measurement apparatus: HAZE METER TC-HIIIDPK, by Tokyo Denshoku, Co,. Ltd.

Sample size: 3 mm in width ×30 mm in length, 0.05 mm in thickness.
Measurement condition: according to JIS-K7105.
Measurement temperature: room temperature (25°C)

Although the internal haze polymeric piezoelectric material according to the invention is preferably as low as possible from the viewpoint of transparency, it is preferably from 0.0% to 40%, more preferably from 0.01 % to 20%, further preferably from 0.01 % to 5%, still further preferably from 0.01% to 2.0%, and especially preferably from 0.01% to 1.0%, from the view point of balancing transparency with piezoelectricity, *etc.*

<Crystallinity>

For the polymeric piezoelectric material according to the invention, the crystallinity obtained using the DSC (Differential Scanning Calorimetry) is preferably from 20% to 80%.
If the crystallinity is 20% or more, the polymeric piezoelectric material is excellent in piezoelectricity.
If the crystallinity is 80% or less, the polymeric piezoelectric material is excellent in transparency, and easily produced because whitening and fracture are unlikely to occur when it is stretched.
The crystallinity is preferably from 25% to 70%, and more preferably from 30% to 50%.

<Standardized Molecular Orientation MORc>

For the polymeric piezoelectric material according to the invention, the standardized molecular orientation, MORc is preferably from 2.0 to 10.0 for the reference thickness of 50 μm measured by a microwave transmission type molecular orientation meter.
If the standardized molecular orientation MORc is 2.0 or more, the polymeric piezoelectric material is excellent in piezoelectricity.
If the standardized molecular orientation ratio MORc is 10.0 or less, the polymeric piezoelectric material is excellent in transparency.
Here, the molecular orientation ratio MOR will be first described before describing the standardized molecular orientation MORc.
The molecular orientation ratio MOR is a value indicating the degree of the orientation of molecules, and measured by the microwave measurement method as below.
A sample (polymeric piezoelectric material) is placed in a microwave resonance wave guide of a well-known microwave molecular orientation meter (also referred to as a microwave transmission type molecular orientation meter) in such a way that the sample surface is perpendicular to the traveling direction of microwave. Then, the sample is rotated by from 0 to 360° in a plane perpendicular to the traveling direction of microwave while being irradiated continuously by the microwave oscillating in a single direction, and the strength of the transmitted microwave is measured to obtain the molecular orientation ratio MOR.
The standardized molecular orientation MORc means a MOR value to be obtained at the reference thickness tc of 50 μm, and can be determined by the following formula.

$$MORc = (tc / t) \times (MOR - 1) + 1$$

(tc: Reference thickness corrected to; t: Sample thickness)
A standardized molecular orientation MORc can be measured by a publicly known molecular orientation meter, e.g. a microwave-type molecular orientation analyzer MOA-2012A or MOA-6000 by Oji Scientific Instruments, at a resonance frequency in the vicinity of 4 GHz or 12 GHz.
In addition, the standardized molecular orientation MORc can be regulated by crystallization conditions in producing a polymeric piezo-electric material (for example, heating temperature and heating time), and the stretching conditions (for example, stretching temperature and stretching speed).
Standardized molecular orientation MORc can also be converted to birefringence Δn, which equals to retardation divided by film thickness.
More specifically, the retardation can be measured by RETS 100, by Otsuka Electronics Co., Ltd. Further, MORc and Δn are approximately in a linearly proportional relationship, and if Δn is 0, MORc is 1
For example, if an polymer (A) is a polylactic acid-type polymer and the birefringence Δn is measured at measurement wavelength of 550 nm, the lower limit 2.0 of a preferable range for the standardized molecular orientation MORc can be converted to the birefringence Δn of 0.005. Further, the lower limit 40 of a preferable range of the product of the standardized molecular orientation MORc multiplied by the crystallinity of a polymeric piezoelectric body can be converted to 0.1 as the product of the birefringence Δn and the crystallinity of an polymeric piezoelectric body.

<Product of Crystallinity and Standardized Molecular Orientation MORc>

For the polymeric piezoelectric material according to the invention, the product of the crystallinity and the standardized molecular orientation MORc is preferably from 40 to 700.
When the product is from 40 to 700, the piezoelectricity and transparency of the polymeric piezoelectric material is well balanced, and the dimensional stability is high. For this reason, when the product is from 40 to 700, the material

can be preferably used as a piezoelectric element described hereinafter.

The product is preferably from 75 to 660, more preferably from 90 to 650, further preferably from 125 to 650, and especially preferably from 150 to 500.

Examples of preferable combinations of the internal haze, the crystallinity, and the product include a combination of the internal haze of 40% or less, the crystallinity of from 20% to 80%, and the product of from 40 to 700.

Examples of preferable combinations of the internal haze and the standardized molecular orientation MORc include a combination of the internal haze of from 0.05% to 5% and the standardized molecular orientation MORc of from 2.0 to 10.0.

<Thickness and Others>

Although the thickness of the polymeric piezoelectric material according to the invention has no particular restriction, it can be, for example, from 10 μm to 1000 μm, preferably from 10 μm to 400 μm, more preferably from 20 μm to 200 μm, further preferably from 20 μm to 100 μm, and especially preferably from 30 μm to 80 μm.

The polymeric piezoelectric material according to the invention is preferably a film subjected to stretching treatment. A preferable method of producing the polymeric piezoelectric material according to the invention will be described later.

<Helical Chiral Polymer (A)>

The polymeric piezoelectric material according to the invention includes a helical chiral polymer (A) having weight-average molecular weight of from 50,000 to 1,000,000 and a optical purity of more than 97.0%ee but less than 99.8%ee.

The helical chiral polymer means a polymer having an optical activity the molecular structure of which is a helical structure.

Examples of the helical chiral polymer (A) include, for example, a polypeptide, a cellulose derivative, a polylactic acid-type polymer, polypropylene oxide, poly(β-hydroxybutyric acid), *etc.*

Examples of the polypeptide include, for example, poly(γ-benzyl glutaric-acid), poly(γ-methyl glutaric-acid), *etc.*

Examples of the cellulose derivative include, for example, cellulose acetate, cyano ethylcellulose, *etc.*

As the helical chiral polymer (A), a compound having a main chain includes a repeating unit represented by the following formula (1):

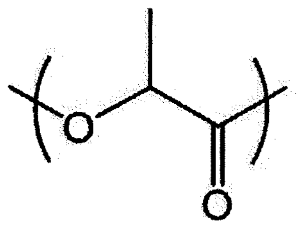

(1)

Examples of the compound including the repeating unit represented by formula (1) include a polylactic acid-type polymer.

The polylactic acid-type polymer means polylactic acid (*i.e.*, a polymer consisting only of repeating unit derived from L-lactic acid and repeating unit derived from D-lactic acid), a copolymer of L-lactic acid, D-lactic acid, and other multi-functional compounds, or any mixture of both the polymers.

Polylactic acid is a long connected polymer from lactic acid polymerized by ester bond, and known to be able to be produced by a lactide process via lactide and a direct polymerization process that heats lactic acid in a solution under reduced pressure and polymerizes it while removing water.

The other multi-functional compounds means multi-functional compounds other than L-lactic acid and D- lactic acid.

Examples of other multi-functional compounds can include a hydroxycarboxylic acid, such as glycolic acid, dimethyl glycolic acid, 3-hydroxybutyric acid, 4-hydroxybutyric acid, 2-hydroxypropanoic acid, 3-hydroxypropanoic acid, 2-hydroxyvaleric acid, 3-hydroxyvaleric acid, 4-hydroxyvaleric acid, 5-hydroxyvaleric acid, 2-hydroxycaproic acid, 3-hydroxycaproic acid, 4-hydroxycaproic acid, 5-hydroxycaproic acid, 6-hydroxycaproic acid, 6-hydroxymethylcaproic acid, and mandelic acid; a cyclic ester, such as glycolide, β-methyl-δ-valerolactone, γ-valerolactone, and ε-caprolactone; a polycarboxylic acid, such as oxalic acid, malonic acid, succinic acid, glutaric acid, adipic acid, pimelic acid, azelaic acid, sebacic acid, undecanedioic acid, dodecanedioic acid, and terephthalic acid, and an anhydride thereof; a polyhydric

alcohol, such as ethyleneglycol, diethyleneglycol, triethyleneglycol, 1,2-propanediol, 1,3-propanediol, 1,3-butanediol, 1,4-butanediol, 2,3-butanediol, 1,5-pentanediol, 1,6-hexanediol, 1,9-nonanediol, 3-methyl-1,5-pentanediol, neopentylglycol, tetramethyleneglycol, and 1,4-hexanedimethanol; a polysaccharide such as cellulose; and an aminocarboxylic acid such as α-amino acid.

The concentration of the repeating unit derived from other multi-functional compounds in the helical chiral polymer (A) (preferably the polylactic acid-type polymer) is preferably 20 mol% or less.

The helical chiral polymer (A) (preferably the polylactic acid-type polymer) can be produced by, for example, processes described in JP-A No. S59-096123, and JP-A No. H7-033861, in which lactic acid is directly dehydration-condensed, and processes described in US Patent Nos. 2,668,182 and 4,057,357, which perform ring-opening polymerization by using lactide which is a ring-shaped dimer of lactic acid.

Further, the helical chiral polymer (A) (preferably the polylactic acid-type polymer) is preferably obtained from polymerization of lactide having an optical purity of more than 97.0%ee and less than 99.8%ee through crystallization operation so that the optical purity of the polymer becomes more than 97.0%ee and less than 99.8% ee.

(Weight-average Molecular Weight)

The helical chiral polymer (A) has a weight-average molecular weight (Mw) of from 50,000 to 1,000,000.

When the weight-average molecular weight of the helical chiral polymer (A) is less than 50,000, the mechanical strength of the polymeric piezoelectric material becomes insufficient. The weight-average molecular weight of the helical chiral polymer (A) is preferably 100,000 or more, and more preferably 200,000 or more.

On the other hand, in a case in which the weight-average molecular weight of the helical chiral polymer (A) exceeds 1,000,000, casting of the polymeric piezoelectric material (for example, forming the material into a film-like shape by extrusion molding) becomes difficult. The weight-average molecular weight of the helical chiral polymer (A) is preferably 800,000 or less, and more preferably 300,000 or less.

Further, the molecular weight distribution (Mw/Mn) of the helical chiral polymer (A) is preferably from 1.1 to 5, more preferably from 1.2 to 4, and further preferably from 1.4 to 3, from a viewpoint of the strength of a polymeric piezoelectric material.

The weight-average molecular weight Mw and the molecular weight distribution (Mw/Mn) of a helical chiral polymer (A) are measured using a gel permeation chromatograph (GPC) by the following GPC measuring method.

- GPC Measuring Apparatus -

GPC-100 by Waters Corp.

- Column -

SHODEX LF-804 by Showa Denko K.K.

- Preparation of Sample -

A helical chiral polymer (A) is dissolved in a solvent (e.g. chloroform) at 40°C to prepare a sample solution with the concentration of 1 mg/mL.

- Measurement Condition -

0.1 mL of a sample solution is introduced into a column at a temperature of 40°C and a flow rate of 1 mL/min by using chloroform as a solvent.

The sample concentration in a sample solution separated by the column is measured by a differential refractometer. Based on polystyrene standard samples, a universal calibration curve is created and the weight-average molecular weight (Mw) and the molecular weight distribution (Mw/Mn) of a helical chiral polymer (A) are calculated.

For a polylactic acid-type polymer, a commercial polylactic acid can be used, and examples thereof include, for example, REVODE 190 by Zhejiang Hisun Biomaterials Co.,Ltd, and Ingeo2500HP by NatureWorks, *etc.*

If a polylactic acid-type polymer is used as a helical chiral polymer and in order to make the weight-average molecular weight (Mw) of the polylactic acid-type polymer 50,000 or higher, it is preferable to produce a helical chiral polymer by a lactide process, or a direct polymerization process.

(Content of Helical Chiral Polymer (A))

The content of the helical chiral polymer (A) is preferably 80 % by mass or more with respect to the total mass of the polymeric piezoelectric material.
Piezoelectric constants tend to be larger when the content is 80% by mass or more.

<Stabilizer>

The polymeric piezo-electric material may include a stabilizer.
As for the stabilizer, it is preferable that the stabilizer has one or more kinds of functional groups selected from the group consisting of a carbodiimide group, an epoxy group, and an isocyanate group and has a weight-average molecular weight of from 200 to 60,000.
This stabilizer can further suppress the hydrolysis reaction of the helical chiral polymer (A) and further improve the stability of the polymeric piezo-electric material (the stability of piezoelectric constants).
Examples of compounds having a carbodiimide group which can be used as stabilizers (carbodiimide compounds) include a monocarbodiimide compound, a polycarbodiimide compound, and a ring-shaped carbodiimide compound.
Examples of a monocarbodiimide compound include dicyclohexylcarbodiimide, dimethylcarbodiimide, diisobutylcarbodiimide, dioctylcarbodiimide, *t*-butylisopropylcarbodiimide, diphenylcarbodiimide, di-*t*-butylcarbodiimide, and di-β-naphthyl carbodiimide, bis-2,6-diisopropyl phenyl carbodiimide, and among others, especially from a standpoint of easy industrial availability, dicyclohexylcarbodiimide, or bis-2,6-diisopropylphenylcarbodiimide is appropriate.
As a polycarbodiimide compound, products of various processes can be used. Products of heretofore known processes for producing polycarbodiimide (for example, U.S.
Patent No. 2941956, Japanese Patent Publication No. S47-33279, J. Org. Chem. 28, 2069-2075 (1963), Chemical Review 1981, Vol. 81, No. 4, p619-621) can be used. Specifically, a carbodiimide compound described in Japanese Patent No. 4,084,953 can be also used.
Examples of a polycarbodiimide compound include poly(4,4'-dicyclohexylmethanecarbodiimide), poly(tetramethylxylylenecarbodiimide), poly(*N,N*-dimethylphenylcarbodiimide), and poly(*N,N*'-di-2,6-diisopropylphenylcarbodiimide), poly(1,3,5- triisopropyl phenylene-2,4-carbodiimide.
The ring-shaped carbodiimide compound can be synthesized on the basis of a process described in JP-A-2011-256337.
As a carbodiimide compound a commercial product may be used, and examples thereof include B2756 (trade name) by Tokyo Chemical Industry Co., Ltd., CARBODILITE (registered trade mark) LA-1 by Nisshinbo Chemical Inc., and STABAXOL (registered trade mark) P, STABAXOL P400, and STABAXOL I (all are trade names) by Rhein Chemie Rheinau GmbH.
The weight-average molecular weight of the stabilizer is from 200 to 60000, as described above, preferably from 200 to 30000, and more preferably from 300 to 18000.
If the molecular weight is within the range, the stabilizer can move more easily, and an effect of improvement in moist heat resistance is realized more affectively.
Stabilizers may be used singly or in combination of two or more thereof.
If the polymeric piezoelectric material includes a stabilizer, the content of the stabilizer is preferably from 0.01 parts by mass to 10 parts by mass with respect to 100 parts by mass of the helical chiral polymer (A).
From the viewpoint of transparency, the content is preferably 2.8 parts by mass or less.
In order to obtain high reliability, the content is preferably 0.7 parts by mass or more.
Examples of a preferable mode of a stabilizer include a mode, in which a stabilizer (B1) having at least one kind of functional group selected from the group consisting of a carbodiimide group, an epoxy group, and an isocyanate group, and having the number-average molecular weight of from 200 to 900, and a stabilizer (B2) having in a molecule two or more functional groups of 1 or more kinds selected from the group consisting of a carbodiimide group, an epoxy group, and an isocyanate group, and having the weight-average molecular weight of from 1,000 to 60,000 are used in combination. In this regard, the weight-average molecular weight of a stabilizer (B1) with the number-average molecular weight of from 200 to 900 is about from 200 to 900, and the number-average molecular weight and the weight-average molecular weight of a stabilizer (B1) give almost the same values.
When stabilizer (B1) and stabilizer (B2) are simultaneously used as a stabilizer, the stabilizer preferably includes a larger amount of the stabilizer (B1) from the viewpoint of improvement in transparency.
Specifically, the stabilizer (B2) is preferably from 10 parts by mass to 150 parts by mass with respect to 100 parts by mass of the stabilizer (B1) from the viewpoint of balancing transparency with moist heat resistance, and preferably from 50 parts by mass to 100 parts by mass.

<Nucleating Agent>

The polymeric piezoelectric material according to the invention may include an nucleating agent (crystallization accelerator).

Examples of the nucleating agent include a polyglycerin ester, ethylene bis hydroxy stearic-acid amide, ethylene bis decanoic acid amide, ethylene bis lauryl acid amide, hexamethylene bis- 12-hydroxy stearic-acid amide, [methylene bis (3,5-G-*tert*-butyl ortho-phenylene) oxy] phosphinic acid sodium, ethylene bis stearic acid amide, ethylene bis behenic acid amide, hexamethylene bis stearic-acid amide, phthalocyanine, *etc.*

<Other Components>

A polymeric piezoelectric material according to the invention may include, to the extent that the advantage of the current embodiment be not compromised, other components other than the above-mentioned materials

Examples of the components include well-known resins exemplified by a polyethylene resin, a polystyrene resin; inorganic fillers such as silica, hydroxyapatite, montmorillonite, *etc*.

However, in a case in which the polymeric piezoelectric material according to the invention includes other components other than the helical chiral polymer (A) (the stabilizers, the nucleating agents, the other components, *etc*.), the content of the other components other than the helical chiral polymer (A) is preferably 20% by mass or less with respect to the total mass of the polymeric piezoelectric material.

[Application of Polymeric Piezoelectric Material]

The polymeric piezoelectric material according to the invention can be used in various fields including a loudspeaker, a headphone, a microphone, a hydrophone, an ultrasonic transducer, an ultrasonic applied measurement instrument, a piezoelectric vibrator, a mechanical filter, a piezoelectric transformer, a delay unit, a sensor, an acceleration sensor, an impact sensor, a vibration sensor, a pressure-sensitive sensor, a tactile sensor, an electric field sensor, a sound pressure sensor, a display, a fan, a pump, a variable-focus mirror, a sound insulation material, a soundproof material, a keyboard, acoustic equipment, information processing equipment, measurement equipment, and a medical appliance.

In this case, a polymeric piezoelectric material according to the invention is preferably used as a piezoelectric element having at least two planes provided with electrodes. It is enough if the electrodes are provided on at least two planes of the polymeric piezoelectric material. There is no particular restriction on the electrode, and examples thereof to be used include ITO, ZnO, IZO (registered trade mark), IGZO (registered trade mark), and an electro conductive polymer.

Especially, if a principal plane of a polymeric piezoelectric material is provided with an electrode, it is preferable to provide a transparent electrode. In this regard, a transparent electrode means specifically that its transmission haze is 20% or less, and total luminous transmittance is 80% or more).

In this regard, a "principal plane" means a surface having the largest area among the surfaces of the polymeric piezoelectric material. The polymeric piezoelectric material according to the invention may have two or more principal planes. For example, in a case in which the polymeric piezoelectric material is a plate-like body having two rectangular surfaces A of 10 mm×0.3 mm, two rectangular surfaces B of 3 mm×0.3 mm, and two rectangular surfaces C of 10 mm×3 mm, the principal planes of the polymeric piezoelectric material are the surfaces C, and thus, the material has two principal planes.

A principal plane having a large area means that the area of the principal plane of the polymeric piezoelectric material is 5 $mm^2$ or more, and the area of the principal plane is preferably 5 $mm^2$ or more.

The piezoelectric element using a polymeric piezoelectric material according to the invention may be applied to the aforementioned various piezoelectric devices including a loudspeaker and a touch panel. In particular, a piezoelectric element provided with a transparent electrode is favorable for applications, such as a loudspeaker, a touch panel, and an actuator.

When the polymeric piezoelectric material according to the invention is applied as a piezo-electric device, the structure of the piezo-electric device is not limited to a structure consisting of only one polymeric piezoelectric material according to the invention having a electric conductor disposed on one surface of the polymeric piezoelectric material, and may be a structure provided with two or more stacked layers of the polymeric piezoelectric material of the present embodiment which has an electric conductor disposed on one surface thereof.

Specifically, examples of the structures include a structure in which units of an electrode and polymeric piezoelectric material are repeatedly layered one on another, and the principal plane of the topmost polymeric piezoelectric material with no cover electrode is finally covered with an electrode. The structure with twice-repeated units is a layered piezo-electric element including an electrode, a polymeric piezoelectric material, an electrode, a polymeric piezoelectric

material, and an electrode, layered one on another in this order. Among the polymeric piezoelectric materials used in the layered piezo-electric element, only one layer needs to be of a polymeric piezoelectric material according to the invention, and other layers are not necessarily of a polymeric piezoelectric material according to the invention.

If the layered piezo-electric element includes plural polymeric piezoelectric materials according to the invention, and if L-form is a main component of a helical chiral polymer (A) included in the polymeric piezoelectric material in one layer, either L-form or D-form may be a main component of the helical chiral polymer (A) included in the polymeric piezoelectric materials in other layers. The location of the polymeric piezoelectric material may be appropriately adjusted according to an end use of the piezoelectric element.

For example, if a first layer of a polymeric piezoelectric material including the L-form of the helical chiral polymer (A) as a main component and a second layer of a polymeric piezoelectric material including the L-form of the helical chiral polymer (A) as main component are layered one above another with an electrode intervening therebetween, it is preferable that the uniaxial stretching direction (main stretching direction) of the first polymeric piezoelectric material intersects, and more preferably perpendicularly the uniaxial stretching direction (main stretching direction) of the second polymeric piezoelectric material so that the displacement directions of the first polymeric piezoelectric material and of the second polymeric piezoelectric material can be aligned, resulting in improvement in the piezoelectricity of the entire layered piezo-electric element.

On the other hand, if the first layer of a polymeric piezoelectric material including the L-form of a helical chiral polymer (A) as a main component and the second layer of a polymeric piezoelectric material including the D-form of a helical chiral polymer (A) as main component are layered one above another with an electrode intervening therebetween, it is preferable that the uniaxial stretching direction (main stretching direction) of the first polymeric piezoelectric material is set to be approximately parallel to the uniaxial stretching direction (main streticing direction) of the second polymeric piezoelectric material so that the displacement directions of the first polymeric piezoelectric material and of the second polymeric piezoelectric material can be aligned, resulting in improvement in the piezoelectricity of the entire layered piezo-electric element.

[Method of Producing Polymeric Piezoelectric Material]

The polymeric piezoelectric material according to the invention does not have any particular restriction in the production process thereof and can be produced by well-known processes.

The raw material of the polymeric piezoelectric material according to the invention can be obtained by mixing (preferably melt-kneading) the helical chiral polymer (A) (and, if necessary, other components).

Preferable modes of melt-kneading include a mode which uses a melt-kneader (for example, a laboblast mixer, by TOYO SEIKI Co., Ltd.) and conducts melt-kneading for from 5 minutes to 20 minutes under conditions of a rotating speed of the mixer of from 30 rpm to 70 rpm and from 180°C to 250°C.

Especially preferable processes for producing the polymeric piezoelectric material according to the invention (a first process and a second process) will now be described.

<First Process>

The first process includes a first step of obtaining a pre-crystallized film by heating a film in an amorphous state including the helical chiral polymer (A) and a second step of stretching the pre-crystallized film principally in a uniaxial direction.

The film in an amorphous state may be one available from the market, or produced by a publicly known film forming means, such as extrusion molding. The film in an amorphous state may be mono-layered or multi-layered.

Examples of the fabricate film in an amorphous state include, for example, a film obtained by heating raw material including a helical chiral polymer (A) to a temperature equal to or higher than the melting point of the helical chiral polymer (A) and performing extrusion-molding followed by quenching. The quenching temperature is, for example, 50°C.

Generally by intensifying a force applied to a film during stretching, there appears tendency that the orientation of the helical chiral polymer (A) is promoted, the piezoelectric constant is enhanced, crystallization is progressed to increase the crystal size, and consequently the transmission haze increases. Further, as a result of increase in internal stress, the rate of dimensional change tends to increase. If a force is applied simply to a film, not oriented crystals, such as spherocrystals , are formed. Poorly oriented crystals such as spherocrystals increase the transmission haze but hardly contribute to increase in the piezoelectric constant. Therefore to produce a film having a high piezoelectric constant, a low transmission haze and a low rate of dimensional change, it is necessary to form efficiently such micro-sized orientated crystals, as contribute to the piezoelectric constant but not increase the transmission haze.

In the first step, for example, prior to stretching the inner part of a film is pre-crystallized to form minute crystals, and thereafter the sheet is stretched. As a result, a force applied to the film during stretching comes to act efficiently on

a low-crystallinity polymer part between a crystallite and a crystallite, so that the helical chiral polymer (A) can be orientated efficiently in the main stretching direction. Specifically, in a low-crystallinity polymer part between a crystallite and a crystallite minute orientated crystals are formed and at the same time spherocrystals formed by pre-crystallization are collapsed and lamellar crystals constituting the spherocrystals are aligned as tied in a row by tie-molecular chains in the stretching direction, so as to attain a desired MORc value. As a result, a film with low values for the transmission haze and the rate of dimensional change can be obtained without compromising remarkably the piezoelectric constant.

For the control of standardized molecular orientation MORc, it is important to regulate the heat treatment time and the heat treatment temperature at the first step, and to regulate the stretching speed and the stretching temperature at the second step.

The production of the polymeric piezoelectric material according to the invention may be performed by, for example, a production process performing continuously each step described hereinafter (continuous uniaxially stretching process), or a production process performing in batch mode each step described hereinafter (batch uniaxially stretching process).

- First Step (pre-crystallization step) -

The first step is a step to obtain a pre-crystallized film by heating a film in an amorphous state including the helical chiral polymer (A).

Treatments through the first step and the second step in the first process may be:

1) a treatment of subjecting a sheet in an amorphous state to heat-treatment to form a pre-crystallized sheet (the first step), and then placing the obtained pre-crystallized sheet in a stretching machine and stretching it (the second step) (off-line step), or 2) a treatment of placing a sheet in an amorphous state in a stretching machine and heating it in the stretching machine to form a pre-crystallized sheet (the first step), and then stretching the obtained pre-crystallized sheet continuously in this stretching machine (the second step) (in-line treatment).

The first step is preferably a step in which the pre-crystallized film is obtained by heating the film in an amorphous state at a temperature T, which satisfies the following formula (2) until the crystallinity becomes 3% - 70%. By this step, the produced polymeric piezoelectric material has an increased piezoelectricity and a transparency.

$$\text{Formula (2): } Tg - 40°C \leq T \leq Tg + 40°C$$

[In formula (2), Tg represents a glass-transition temperature of a helical chiral polymer (A).]

In the first step, the heat-treatment time for pre-crystallizing is preferably adjusted so that a desirable crystallinity is satisfied, and in the polymeric piezoelectric material after stretching (after the second step, or after an annealing step, if annealing described hereinafter is performed), the product of MORc and the crystallinity is adjusted within the above described preferable range.

If the heating treatment time is prolonged, the crystallinity after stretching becomes also higher and the standardized molecular orientation MORc after stretching tends to become also higher. If the heating treatment time is made shorter, the crystallinity after stretching becomes lower and the standardized molecular orientation MORc after stretching also tends to become lower.

If the crystallinity of a pre-crystallized film before stretching becomes high, the film becomes stiff and a larger stretching stress is exerted on the film, and therefore such parts of the film, where the crystallinity is relatively low, are also orientated highly to enhance also the standardized molecular orientation MORc after stretching. Reversely, conceivably, if the crystallinity of a pre-crystallized film before stretching becomes low, the film becomes soft and a stretching stress is exerted to a lesser extent on the film, and therefore such parts of the film, where the crystallinity is relatively low, are also orientated weakly to lower also the standardized molecular orientation MORc after stretching.

The heating treatment time varies depending on heating treatment temperature, film thickness, the molecular weight of a helical chiral polymer (A), and the kind and quantity of an additive. While, if a film in an amorphous state is preheated at a temperature allowing the sheet to crystallize on the occasion of preheating which may be carried out before a stretching step (second step) described below, the actual heating treatment time for crystallizing the sheet corresponds to the sum of the above preheating time and the heating treatment time at the pre-crystallization step before the preheating.

The heat-treatment time for the film in an amorphous state is usually 5 seconds or more and 60 minutes or less, and preferably from 1 minutes to 30 minutes from the viewpoint of stabilization of production conditions. If, for

example, a film in an amorphous state including polylactic acid as a helical chiral polymer (A) is pre-crystallized, heating at from 60°C to 170°C, for from 5 seconds to 60 minutes (preferably from 1 minutes to 30 minutes) is preferable.

For imparting efficiently piezoelectricity, transparency, and high dimensional stability to a film after stretching, it is preferable to adjust the crystallinity of a pre-crystallized film before stretching.

The reason behind the improvement of the piezoelectricity or the dimensional stability by stretching is believed to be that a stress by stretching is concentrated on parts of a pre-crystallized film where the crystallinity, presumably in a state of spherocrystal, is relatively high, so that spherocrystal are destroyed and aligned to enhance the piezoelectricity (piezoelectric constant $d_{14}$), and at the same time the stretching stress is exerted through the spherocrystals on parts where the crystallinity is relatively low, promoting orientation to enhance the piezoelectricity (piezoelectric constant $d_{14}$).

The crystallinity of a film after stretching (if an annealing treatment described below is conducted, after annealing step) is set to aim at from 20% to 80%, preferably at from 25% to 70%, preferably at from 30% to 50%. Consequently, the crystallinity of a pre-crystallized film just before stretching can be set at from 3% to 70%, preferably at from 10% to 60%, and more preferably at from 15% to 50%.

The measurement of the crystallinity of a pre-crystallized film may be carried out similarly as the measurement of the crystallinity of a polymeric piezoelectric material according to the invention after stretching.

The thickness of a pre-crystallized film is selected mainly according to an intended thickness of a polymeric piezoelectric material by means of stretching at the second process and the stretching ratio, and is preferably from 50 μm to 1000 μm, and more preferably about from 200 to 800 μm.

- Second Step (stretching step) -

The stretching step in a stretching process as the second step does not have any particular restriction, and various stretching processes, such as uniaxial stretching, biaxial stretching and a solid state stretching can be used.

By stretching a polymeric piezoelectric material, a polymeric piezoelectric material having a large area principal plane can be obtained.

If a polymeric piezoelectric material is stretched solely by a tensile force as in the case of a uniaxial stretching or a biaxial stretching, the stretching temperature of a polymeric piezoelectric material is preferably in a range of from 10°C to 20°C higher than the glass transition temperature of a polymeric piezoelectric material.

The stretching ratio in a stretching treatment is preferably from 2.0-fold to 30-fold, and stretching in a range of from 2.5-fold to 15-fold is more preferable.

The second step (stretching step) stretches a pre-crystallized film principally in a uniaxial direction. The stretching direction may be the MD direction for longitudinal stretching, or the TD direction for transverse stretching.

By this step, it is expected that the molecular chain of a helical chiral polymer (A) can be aligned in a single direction, and that a densely oriented crystal can be produced.

In this regard an expression "stretching principally in a uniaxial direction" means (i) stretching only in a specific direction (i.e., only uniaxially stretching), or (ii) in the case of stretching in a specific direction and another direction other than the specific direction, stretching such that the stretching ratio in the specific direction ("main stretching direction") is higher than that in another direction (hereinafter, also referred to as "secondary stretching direction").

In this step, in the case of stretching both in the main stretching direction and in the secondary stretching direction, the ratio of stretching in the secondary stretching direction to that in the main strethcing direction is preferably 50% or less (preferably 30% or less, and more preferably 10% or less).

When a pre-crystallized film is stretched, the sheet may be preheated immediately before stretching so that the film can be easily stretched. Since the preheating is performed generally for the purpose of softening the film before stretching in order to facilitate the stretching, the same is normally performed avoiding conditions that promote crystallization of a film before stretching and make the film stiff. Meanwhile, in the first process pre-crystallization is performed before stretching, and the preheating may be performed combined with the pre-crystallization. Specifically, by conducting the preheating at a higher temperature than a temperature normally used or for longer time conforming to the heating temperature or the heat treatment time at the aforementioned pre-crystallization step, preheating and pre-crystallization can be combined.

-Annealing Treatment Step -

The first process may include, after the second step (stretching step), an annealing treatment step of annealing the polymeric piezoelectric material after a stretching treatment.

The temperature of an annealing treatment is preferably from about 80°C to 160°C and more preferably from 100°C to 155°C.

A method for applying a high temperature in an annealing treatment does not have any particular restriction, and examples thereof include a direct heating method by using heating rolls, hot air heaters, and infrared heaters, *etc.*,

and a method for dipping a polymeric piezoelectric material in a heated liquid such as heated silicone oil.

In this case, if a polymeric piezoelectric material is deformed by linear expansion, it becomes practically difficult to obtain a flat film, and therefore high temperature is applied preferably under application of a certain tensile stress (e.g. 0.01 MPa or more but 100 MPa or less) on a polymeric piezoelectric material to prevent the polymeric piezoelectric material from sagging.

The temperature application time at an annealing treatment is preferably from 1 sec to 60 min, more preferably from 1 sec to 300 sec, and further preferable is heating for from 1 sec to 60 sec. If the temperature application time in the annealing treatment is 60 min or less, the growth of spherocrystals from molecular chains and decrease in orientation degree of in an amorphous part can be better suppressed, and the piezoelectricity can be more improved.

A polymeric piezoelectric material treated for annealing as described above is preferably quenched after the annealing treatment. In connection with an annealing treatment, "quench" means that a polymeric piezoelectric material treated for annealing is dipped, for example, in ice water immediately after the annealing treatment and chilled at least to the glass transition temperature Tg or lower, and between the annealing treatment and the dipping in ice water, etc. there is no other treatment.

Examples of a quenching method include a dipping method, by which a polymeric piezoelectric material treated for annealing is dipped in a cooling medium, such as water, ice water, ethanol, ethanol or methanol including dry ice, and liquid nitrogen; a cooling method, by which a liquid with the low vapor pressure is sprayed for chilling by evaporation latent heat thereof. For chilling continuously a polymeric piezoelectric material, quenching by contacting a polymeric piezoelectric material with a metal roll regulated at a temperature below the glass transition temperature Tg of the polymeric piezoelectric material is possible.

The number of quenches may be once or two times or more; or annealing and quenching can be repeated alternately.

The method of producing the polymeric piezoelectric material according to the invention may includes the stretching step and the annealing treatment step in this order. The stretching step and the annealing treatment step can be the same steps as the above described steps.

In the this process, the above described pre-crystallization step is not necessarily performed.

In other words, other embodiments of the method of producing the polymeric piezoelectric material according to the invention include a method of producing a polymeric piezoelectric material including the step of stretching principally in a uniaxial direction a film including a helical chiral polymer (A) and the crystallization agent, and the annealing treatment step in this order.

Specifically, in the case of heating a helical chiral polymer (A) and the crystallization agent to a temperature more than or equal to the melting point of the helical chiral polymer (A) to shape a film and quenching it to obtain a film in an amorphous state, the film can be pre-crystallized by the adjustment of this quenching condition, and thus, the polymeric piezoelectric material according to the invention can be produced without the above described pre-crystallization step.

<Second Process>

The second process is a process including a step of stretching a film including the helical chiral polymer (A) and an annealing treatment step in this order.

As the step of stretching the film principally in a uniaxial direction and the annealing treatment step are the same as those in the first process, respectively, their descriptions will be omitted.

The second process is not necessarily provided with the first step in the first embodiment (pre-crystallization step).

Examples

The embodiment according to the invention will be described below in more details by way of Examples, provided that the current embodiment is not limited to the following Examples to the extent not to depart from the spirit of the embodiment.

[Example 1]

<Production of Polymeric Piezoelectric Material>

To 100 parts by mass of polylactic acid (PLA) as a helical chiral polymer (REVODE 190 (trade name), by Zhejiang Hisun Biomaterials Co.,Ltd, glass-transition temperature 60°C) was added 1.0 parts by mass of a stabilizer, and dry-blended to prepare a source material. The stabilizer was a mixture of Stabaxol P400 (poly(1,3,5-triisopropyl

phenylene-2,4-carbodiimide), by Rhein Chemie Corporation; weight-average molecular weight 20,000) (10 parts by mass) and Stabaxol I (bis-2,6-diisopropyl phenyl carbodiimide; molecular weight 363) (60 parts by mass) by Rhein Chemie Corporation, and CARBODILITE LA-1 (poly(4,4'-dicyclo hexyl methane carbodiimide), by Nisshinbo Chemical Inc.; weight-average molecular weight ca. 2000) (30 parts by mass).

The prepared source material was placed in an extruder hopper, extruded from a T die while heating at from 220°C to 230°C, and brought into contact with a cast roll at 50°C for 0.3 minutes to obtain a pre-crystallized film having a thickness of 150 μm (pre-crystallization step). The crystallinity of the obtained pre-crystallized sheet was determined to be 6%.

Next, the obtained pre-crystallized sheet was started to be stretched at an stretching speed of 3 m/min by the roll-to-roll while heated to 70°C and uniaxially stretched up to 3.5-fold in the MD direction, and un uniaxially-stretched film was obtained (stretching step). The thickness of the obtained uniaxially-stretched film was 47.2 μm.

Then, the uniaxially-stretched film was brought into contact with a roll heated to 145°C by roll-to-roll for 15 seconds, and annealed followed by quenching to obtain a polymeric piezoelectric material (polymeric piezoelectric film) (annealing treatment step).

<Weight-average Molecular Weight and Molecular Weight Distribution of Helical Chiral Polymer>

The weight-average molecular weight (Mw) and molecular weight distribution (Mw/Mn) of a helical chiral polymer (polylactic acid) included in the polymeric piezoelectric material were measured by the following GPC measuring method by using a gel permeation chromatograph (GPC).

The result is shown in Table 1.

- GPC Measuring Method -

• Measuring Apparatus

GPC-100 available from Waters

• Column

Shodex LF-804 by Showa Denko K.K.

• Preparation of Sample Solution

The polymeric piezoelectric material was dissolved into a solvent [chloroform] at 40°C to prepare a sample solution having a concentration of 1 mg/mL.

• Measuring Conditions

0.1 mL of a sample solution was introduced into the column at a temperature of 40°C, at a flow rate of 1 mL/min by using chloroform as a solvent, the concentration of the sample contained in the sample solution and separated by the column was measured by a differential refractometer. The weight-average molecular weight (Mw) of polylactic acid was calculated on the basis of a universal calibration curve created on the basis of standard polystyrene samples.

<Optical Purity of Helical Chiral Polymer>

The optical purity of a helical chiral polymer (polylactic acid) contained in the polymeric piezoelectric material was measured in the following manner.

The result is shown in Table 1.

Into a 50 mL Erlenmeyer flask 1.0 g of a weighed-out sample (the polymeric piezoelectric material) was charged, to which 2.5 mL of IPA (isopropyl alcohol) and 5 mL of a 5.0 mol/Lm sodium hydroxide aqueous solution were added to prepare a sample solution.

The Erlenmeyer flask containing the sample solution was then placed in a water bath at the temperature of 40°C, and stirred for about 5 hours until polylactic acid was completely hydrolyzed.

After the sample solution after the stirring for 5 hours was cooled down to room temperature, 20 mL of 1.0 mol/L hydrochloric acid solution was added for neutralization, and then, the Erlenmeyer flask was stoppered tightly and stirred well.

Next, The sample solution (1.0 mL) was dispensed into a 25 mL measuring flask, to which a mobile phase in

the following composition was added to obtain 25 mL of an HPLC sample solution 1.

Into an HPLC apparatus was injected 5μL of the obtained HPLC sample solution 1, and HPLC measurement was performed under the following HPLC measuring conditions. From the obtained measurement result, a peak area originated from the D-form of polylactic acid and that originated from the L-form of polylactic acid were calculated to derive the amounts of the L-form and the D-form.

Optical purity (%ee) was obtained on the basis of the obtained result.

The result is shown in the following Table 1.

- HPLC Measuring Conditions -

• Column

Optical resolution column, SUMICHIRAL OA5000, by Sumika Chemical Analysis Service, Ltd.

• HPLC Apparatus

Liquid chromatography by Jasco Corporation

• Column Temperature

25°C

• Composition of Mobile Phase

1.0 mM of copper (II) sulfate buffer/IPA = 98/2 (V/V)
(In this mobile phase, the ratios of copper (II) sulfate, IPA, and water satisfy copper (II) sulfate /IPA/water = 156.4 mg/20 mL/980 mL.)

• Flow rate of mobile phase

1.0 mL/min

• Detector

Ultraviolet detector (UV254 nm)

<Melting Point Tm and Crystallinity of Polymeric Piezoelectric material>

The melting point Tm and the crystallinity of the polymeric piezoelectric material were measured in the following manner.

The result is shown in the following Table 1.

10 mg of the polymeric piezoelectric material was weighed accurately and a melting endothermic curve was obtained from the measurement of the material using a differential scanning calorimeter (DSC-1, by Perkin Elmer Inc.) at a temperature increase rate of 10°C/min. From the obtained melting endothermic curve the melting point Tm, and crystallinity were obtained.

<Standardized Molecular Orientation MORc>

A microwave molecular orientation meter MOA6000 by Oji Scientific Instruments was used to measure the standardized molecular orientation MORc of the polymeric piezoelectric material. The reference thickness tc was set to be 50 μm.

The result is shown in Table 1.

<Product of Crystallinity and MORc>

The product of the crystallinity and the MORc [crystallinity × MORc] was calculated.

The result is shown in Table 1.

<Internal Haze of Polymeric Piezoelectric Material>

The internal haze of the polymeric piezoelectric material was measured according to one example of measurement method of the internal haze.
The result is shown in the following Table 1.

<Birefringence of Polymeric Piezoelectric material>

Under the following conditions, the in-plane phase difference (phase difference in in-plane direction) Re of the polymeric piezoelectric material was measured, and the obtained in-plane phase difference was divided by the thickness of the polymeric piezoelectric material to obtain the birefringence of the polymeric piezoelectric material.
The result is shown in the following Table 1.

• Measuring Conditions of In-plane Phase Difference -

- Measurement wavelength --- 550 nm
- Measurement apparatus --- Phase difference film and optical material inspection apparatus RETS-100 by Otsuka Electronics Co., Ltd.

<Tear Strength of Polymeric Piezoelectric material>

The tear strength of the polymeric piezoelectric material was measured in the following manner.
First, as shown in Fig. 1, a specimen 12 for tear strength measurement (specimen specified by JIS K 7128-3(1998)) was cut out of a film 10 of the polymeric piezoelectric material. At this time, as shown in Fig. 1, the specimen was cut so that the longitudinal direction of the specimen 12 is parallel to the TD direction of the film 10.
Then, for the cut specimen 12, tear strength upon tearing the central part in the longitudinal direction of the specimen 12 in the MD direction of the film was measured by the measurement method according to the "Right angled tear method" of JIS K 7128-3(1998).
The result is shown in the following Table 1.

<Piezoelectric Constant $d_{14}$ (before and after reliability test), Increasing Rate (%) of Polymeric Piezoelectric material>

The piezoelectric constant $d_{14}$ of the polymeric piezoelectric material was measured according to one example of measurement method of the piezoelectric constant $d_{14}$ by the stress-charge method (25°C). This measurement was performed for each of the polymeric piezoelectric material before a reliability test and the polymeric piezoelectric material after the reliability test.
The expression "before a reliability test" means a time within 24 hours after the production of the material.
In addition, the expression "after the reliability test" means a time after performing the reliability test under a condition of 85°C for 504 hours, on the polymeric piezoelectric material before the reliability test.
The increasing rate (%) of the piezoelectric constant $d_{14}$ was calculated according to the foregoing formula (A) on the basis of an obtained result.
The results of the piezoelectric constant $d_{14}$ before the reliability test, the piezoelectric constant $d_{14}$ after the reliability test, and the increasing rate (%) of the piezoelectric constant $d_{14}$ are shown in the following Table 1.

[Example 2]

The same operation was done as in the Example 1 except that REVODE 190 in the Example 1 was replaced to Ingeo™ Biopolymer 2500HP (glass-transition temperature 60°C) which is polylactic acid (PLA) by NatureWorks LLC.
The result is shown in the following Table 1.

[Comparative Example 1]

The same operation was done as in the Example 1 except that REVODE 190 in the Example 1 was replaced to Ingeo™ Biopolymer 4032D which is polylactic acid (PLA) by NatureWorks LLC.
The result is shown in the following Table 1.

[Comparative Example 2]

The same operation was done as in the Example 1 except that REVODE 190 in the Example 1 was replaced to PURASORB PL32 which is polylactic acid (PLA) by PURAC Co., Ltd.

The result is shown in the following Table 1.

For Examples 1, 2 and Comparative Examples 1, 2, the results of increasing rate (%) of the piezoelectric constant $d_{14}$ and the results of tear strength are shown in Fig. 2. To the

Fig. 2 were added an approximate curve by a quadratic polynomial based on the data of increasing rate of piezoelectric constant $d_{14}$ and an approximate linear line based on the data of tear strength.

[Table 1]

| | helical chiral polymer | | | | polymeric piezoelectric material | | | | | | | | | |
|---|---|---|---|---|---|---|---|---|---|---|---|---|---|---|
| | seed | Mw | Mw/Mn | optical purity [%ee] | Tm[°C] | Crystallinity [%] | MORc | crystallinity×MORc | internal haze [%] | birefringence | Tear strength [N/mm] | $d_{14}$[pC/N] Before reliability test | $d_{14}$[pC/N] After reliability test | Increasing rate of $d_{14}$ [%] |
| Example 1 | PLA | 200,000 | 1.8 | 99.0 | 174.3 | 56.0 | 5.46 | 305.8 | 0.6 | 0.0230 | 35.6 | 7.1 | 7.3 | 2.4 |
| Example 2 | PLA | 200,000 | 1.8 | 99.0 | 174.2 | 58.2 | 5.67 | 330.0 | 0.7 | 0.0233 | 32.1 | 7.0 | 7.2 | 2.1 |
| Comparative Example 1 | PLA | 200,000 | 1.9 | 97.0 | 166.8 | 44.4 | 4.72 | 209.6 | 0.2 | 0.0206 | 44.2 | 6.3 | 6.8 | 7.9 |
| Comparative Example 2 | PLA | 320,000 | 1.6 | 99.8 | 185.0 | 60.1 | 6.11 | 367.2 | 0.9 | 0.0242 | 29.1 | 7.2 | 7.4 | 2.8 |

As seen in Table 1, for the polymeric piezoelectric materials of Example 1 and 2 which include a helical chiral polymer (A) (PLA) having a weight-average molecular weight of from 50,000 to 1,000,000 and an optical purity of more than 97.0%ee but less than 99.8%ee, and which have a piezoelectric constants $d_{14}$ of 1pC/N or more, strong tear strengths and low increasing rates of $d_{14}$ (*i.e.*, excellent thermal stability) were both realized.
By contrast, for Comparative Example 1 in which the optical purity of the contained PLA was 97.0%ee, the increasing rate of d14 was high.
Further, for Comparative Example 2 in which the optical purity of the contained PLA was 99.8%ee, the tear strength was weak.
The disclosure of Japan Patent Application 2013-244320 filed November 26, 2013 is herein incorporated by reference in its entirety.
All publications, patent applications, and technical standards described in this specification are herein incorporated by reference to the same extent as if each individual publication, patent application, or technical standard was specifically and individually indicated to be incorporated by reference.

[Description of symbols]

10 Film (polymeric piezoelectric material)
12 Specimen

## Claims

1. A polymeric piezoelectric material comprising a helical chiral polymer (A) having a weight-average molecular weight of from 50,000 to 1,000,000 and an optical purity of more than 97.0%ee but less than 99.8%ee as calculated by the following formula, wherein a piezoelectric constant $d_{14}$ measured at 25°C by a stress-charge method is 1 pC/N or more:

formula: optical purity (%ee) = 100 × |L-form amount - D-form amount| / (L-form amount + D-form amount),

wherein, in the formula, an amount of L-form (% by mass) and an amount of D-form of an optically active polymer (% by mass), are values obtained by a method using a high-performance liquid chromatography (HPLC).

2. The polymeric piezoelectric material according to claim 1, wherein the optical purity is from 98.0%ee to 99.6%ee.

3. The polymeric piezoelectric material according to claim 1 or claim 2, wherein the optical purity is more than 98.5%ee but less than 99.6%ee.

4. The polymeric piezoelectric material according to claim 1 or claim 2, wherein:

an internal haze with respect to visible light is 40% or less,
a crystallinity obtained by a DSC method is from 20% to 80%, and
a product of the crystallinity and a standardized molecular orientation MORc measured by a microwave transmission type molecular orientation meter based on a reference thickness of 50 μm is from 40 to 700.

5. The polymeric piezoelectric material according to claim 1 or claim 2, wherein:

an internal haze with respect to visible light is from 0.05% to 5%, and
a standardized molecular orientation MORc measured by a microwave transmission type molecular orientation meter based on a reference thickness of 50 μm is from 2.0 to 10.0.

6. The polymeric piezoelectric material according to claim 1 or claim 2, wherein the helical chiral polymer (A) is a polylactic acid-type polymer having a main chain comprising a repeating unit represented by the following formula (1):

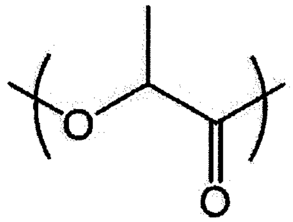

(1)

.

7. The polymeric piezoelectric material according to claim 1 or claim 2, wherein a content of the helical chiral polymer (A) is 80 % by mass or more.

8. A method of producing the polymeric piezoelectric material according to claim 1 or claim 2, the method comprising:

a first step of heating a film in an amorphous state including the helical chiral polymer (A) to obtain a pre-crystallized film; and
a second step of stretching the pre-crystallized film principally in a uniaxial direction.

9. The method of producing the polymeric piezoelectric material according to claim 8, wherein the first step heats the film in an amorphous state at a temperature T, which satisfies the following formula (2) until the crystallinity becomes from 3% to 70%, to obtain the pre-crystallized film:

$$\text{Formula (2): } Tg - 40°C \leq T \leq Tg + 40°C,$$

wherein in formula (2), Tg represents a glass-transition temperature (°C) of the helical chiral polymer (A).

10. The method of producing the polymeric piezoelectric material according to claim 8, wherein the first step heats the film in an amorphous state including polylactic acid as the helical chiral polymer (A) at from 60°C to 170°C for from 5 seconds to 60 minutes, to obtain the pre-crystallized film.

11. The method of producing the polymeric piezoelectric material according to claim 8, further comprising an annealing treatment step of conducting an annealing treatment after the second step.

[Fig. 1]

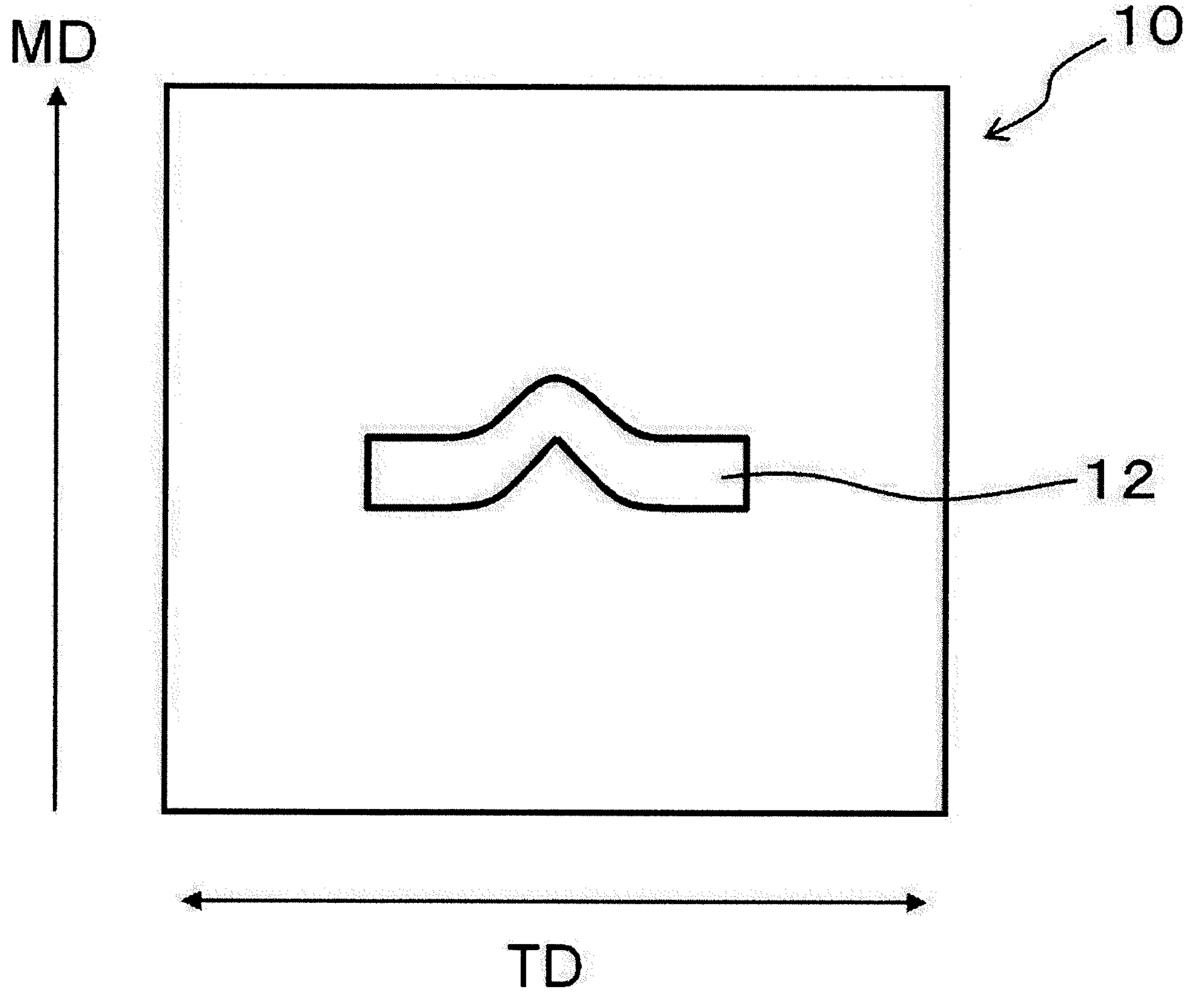

[Fig. 2]

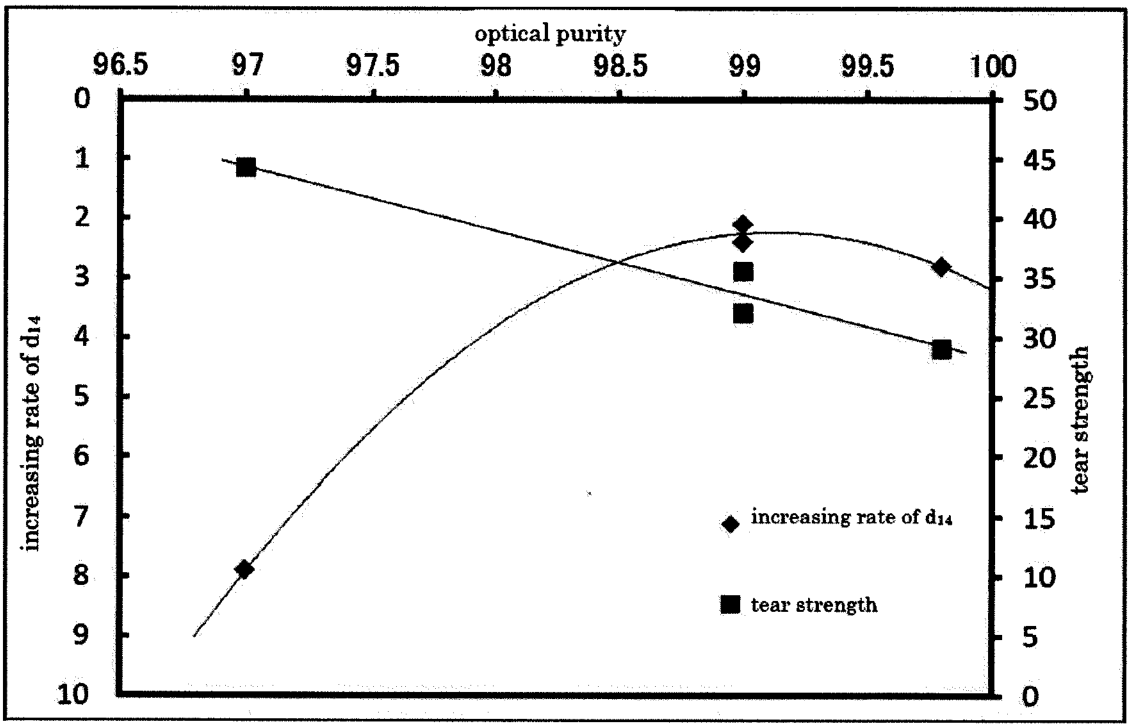
optical purity
96.5
97
97.5
98
98.5
99
99.5
100
0
1
2
3
4
5
6
7
8
9
10
increasing rate of $d_{14}$
50
45
40
35
30
25
20
15
10
5
0
tear strength
increasing rate of $d_{14}$
tear strength

## INTERNATIONAL SEARCH REPORT

International application No.
PCT/JP2014/079773

A. CLASSIFICATION OF SUBJECT MATTER
*H01L41/193*(2006.01)i, *C08G63/06*(2006.01)i, *H01L41/33*(2013.01)i, *H01L41/45*(2013.01)i

According to International Patent Classification (IPC) or to both national classification and IPC

B. FIELDS SEARCHED

Minimum documentation searched (classification system followed by classification symbols)
H01L41/193, C08G63/06, H01L41/33, H01L41/45

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2014 |
| Kokai Jitsuyo Shinan Koho | 1971-2014 | Toroku Jitsuyo Shinan Koho | 1994-2014 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>Y | WO 2012/026494 A1 (Mitsui Chemicals, Inc.), 01 March 2012 (01.03.2012), claims 1 to 4, 12 to 15, 17; paragraphs [0013], [0016], [0061], [0107]<br>& JP 2012-235086 A & US 2012/0132846 A1<br>& EP 2469618 A1 & CN 102484199 A<br>& KR 10-2012-0058536 A | 1-8,10,11<br>9 |
| Y | WO 2013/089148 A1 (Mitsui Chemicals, Inc.), 20 June 2013 (20.06.2013), paragraph [0071]<br>& JP 5313414 B1 & US 2014/0051825 A1<br>& EP 2662910 A1 & CN 103493235 A<br>& KR 10-2014-0003616 A | 9 |

☐ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 25 December 2014 (25.12.14) | 13 January 2015 (13.01.15) |
| Name and mailing address of the ISA/<br>Japan Patent Office<br>Facsimile No. | Authorized officer<br><br>Telephone No. |

Form PCT/ISA/210 (second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 5152638 A
- JP 2011243606 A
- JP S59096123 A
- JP H7033861 A
- US 2668182 A
- US 4057357 A
- US 2941956 A
- JP S4733279 B
- JP 4084953 B
- JP 2011256337 A
- JP 2013244320 A


### Non-patent literature cited in the description


- *J. Org. Chem.,* 1963, vol. 28, 2069-2075
- *Chemical Review,* 1981, vol. 81 (4), 619-621